# FASCICULE DE BREVET EUROPEEN

(11) **EP 2 612 361 B1**
(45) Date de publication et mention de la délivrance du brevet: **19.09.2018**
(21) Numéro de dépôt: 11748946.8
(22) Date de dépôt: 25.08.2011
(51) Int. Cl.: H01L 31/0224, H01L 31/05, H01L 21/44

(54) **CELLULE PHOTOVOLTAÏQUE AVEC CONDUCTEURS DISCONTINUS**
FOTOVOLTAIKZELLE MIT UNTERBROCHENEN LEITERN
PHOTOVOLTAIC CELL HAVING DISCONTINUOUS CONDUCTORS

(30) Priorité: 30.08.2010 FR 1056854; 30.08.2010 FR 1056853
(43) Date de publication de la demande: 10.07.2013
(73) Titulaire: Commissariat à l'Énergie Atomique et aux Énergies Alternatives, 75015 Paris (FR)
(72) Inventeur: BETTINELLI, Armand, F-38500 Coublevie (FR); PILAT, Eric, F-73100 Brison-Saint-Innocent (FR)
(74) Mandataire: Novaimo
(86) Numéro de dépôt international: PCT/EP2011/064671
(87) Numéro de publication internationale: WO 2012/028537

(56) Documents cités:
- WO-A1-00/44051
- WO-A1-2005/098969
- WO-A1-2006/137746
- US-A- 4 301 322
- US-A- 4 590 327
- US-A- 5 726 065
- US-A1- 2010 000 602

## Description

L'invention concerne un procédé de réalisation d'un ou plusieurs conducteurs électriques sur un dispositif photovoltaïque, particulièrement adapté à la réalisation des conducteurs de collecte sur une cellule photovoltaïque, ainsi qu'un procédé de fabrication d'une cellule photovoltaïque intégrant un tel procédé. Elle concerne aussi une unité de production de cellules photovoltaïques mettant en oeuvre un tel procédé et une cellule photovoltaïque en tant que telle obtenue par un tel procédé.

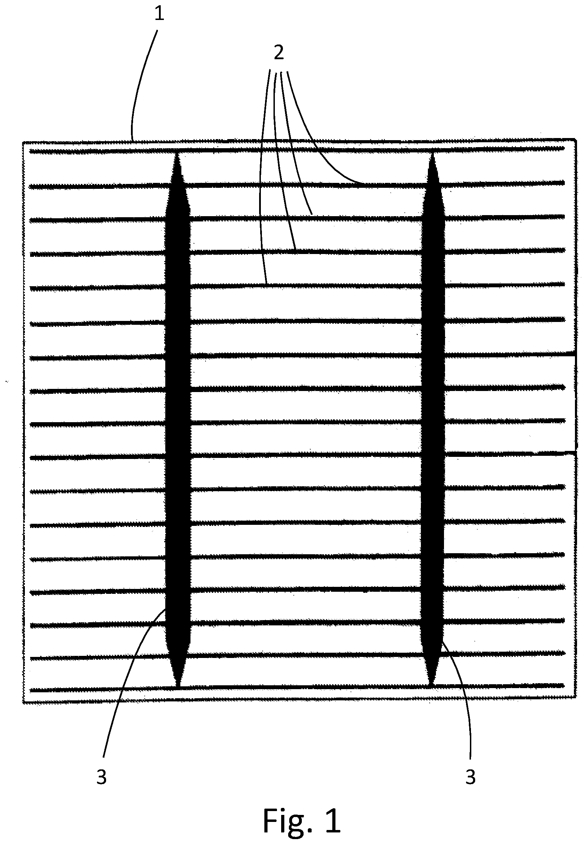

Une cellule photovoltaïque est fabriquée à l'aide d'une plaque en matériau semi-conducteur, généralement en silicium, connu sous sa dénomination anglaise de « wafer ». Cette fabrication nécessite en particulier la formation de conducteurs électriques sur la surface de cette plaque. La figure 1 illustre la surface d'une telle plaque 1 selon l'état de la technique, qui comprend des premiers conducteurs parallèles de fine largeur, appelés conducteurs de collecte 2 ou doigts de collecte, dont la fonction est de collecter les électrons créés dans le silicium par la lumière. La surface de la plaque 1 comprend de plus d'autres conducteurs parallèles plus larges 3, appelés généralement bus, orientés dans une direction perpendiculaire aux conducteurs de collecte 2, dont la fonction est de conduire des charges électriques plus élevées, de cellules photovoltaïques en cellules photovoltaïques. Tous ces conducteurs 2, 3 sont obtenus par différentes techniques permettant de former des lignes conductrices continues, s'étendant de manière continue sur toute la longueur et la largeur de la plaque.

Pour réaliser ces conducteurs, une méthode de l'état de la technique consiste par exemple à déposer une encre conductrice par sérigraphie sur la plaque, avec une ou deux impression(s) sérigraphique(s). Un tel procédé ne permet pas d'obtenir une géométrie idéale, notamment en ce qui concerne la régularité de la hauteur de la couche d'encre déposée, et ne permet pas de former des conducteurs suffisamment performants. En effet, la performance électrique de ces conducteurs est très sensible à leur géométrie, et notamment au ratio épaisseur/largeur, l'épaisseur se mesurant dans la direction verticale perpendiculaire à la plaque 1, et la largeur se mesurant dans la direction horizontale, transversale au conducteur.

En variante, le document EP0729189 propose d'utiliser une autre technique d'impression pour réaliser ces conducteurs, qui consiste à remplacer le masque tissu de la sérigraphie par un pochoir ou feuillard métallique, aussi appelé par sa dénomination anglaise de « stencil », dans lequel sont réalisées des ouvertures traversantes. Toutefois, pour ne pas fragiliser ces masques métalliques et obtenir leur comportement optimal lors de l'impression, il n'est pas possible de réaliser des ouvertures de trop grande surface et le procédé nécessite la superposition d'au moins deux impressions, à partir de deux masques distincts complémentaires. Pour cette raison, ce procédé reste complexe et coûteux.

D'autre part, les conducteurs plus larges 3 sont recouverts en général par un ruban métallique, en cuivre, soudé sur toute sa longueur, à partir d'un ruban de cuivre recouvert d'un alliage de soudure. Ce ruban s'étend sur toute la longueur de la cellule et sert de connecteur pour les cellules entre elles, dont les rubans sont soudés pour assurer la connexion électrique de plusieurs cellules pour former un module photovoltaïque.

La fixation d'un tel ruban de cuivre sur une cellule photovoltaïque s'effectue en disposant le ruban sur le conducteur 3, puis en approchant différentes têtes de soudure en appui, dont la chaleur transmise, par infrarouge ou air chaud en général, permet d'obtenir la soudure du ruban de cuivre sur toute sa longueur, dont la conduction thermique favorise la transmission de la chaleur sur toute sa longueur et donc la réalisation continue de la soudure. On obtient ainsi un ruban de cuivre soudé sur toute la longueur du conducteur 3 en face avant de la cellule photovoltaïque.

L'interconnexion de plusieurs cellules pour former un module se fait aussi par soudure entre les différents rubans de cuivre. L'augmentation de la température lors de ces soudures et les différences de coefficients de dilatation des différents matériaux d'une cellule photovoltaïque représente un risque d'endommagement de la structure des cellules photovoltaïques : en effet, il apparait parfois des microfissures dans la structure du silicium. De plus, les cellules photovoltaïques subissent aussi des contraintes dues aux variations de température lors de leur simple utilisation, qui ajoutent des risques de détérioration de la cellule du fait des phénomènes de dilatation. Ces risques augmentent avec l'épaisseur du ruban de cuivre utilisé et peuvent engendrer des baisses de performance significatives d'un dispositif photovoltaïque. Par ailleurs, les cellules sont aujourd'hui de plus en plus minces, donc de plus en plus sensibles aux contraintes et les rubans de cuivre sont de plus en plus épais pour répondre à l'augmentation du courant dû à l'amélioration de l'efficacité de conversion de ces cellules.

Le document WO00/44051 décrit un procédé de réalisation de conducteurs d'une cellule photovoltaïque.

Ainsi, un objet général de l'invention est de proposer une solution de réalisation d'un conducteur électrique sur une plaque d'un dispositif photovoltaïque qui réduit les inconvénients des solutions de l'état de la technique.

Plus précisément, l'invention cherche à atteindre tout ou partie des objets suivants :
Un premier objet de l'invention est de proposer une solution de réalisation d'un conducteur électrique sur une cellule photovoltaïque permettant l'optimisation de la performance de la cellule photovoltaïque résultante.

Un second objet de l'invention est de proposer une solution de réalisation d'un conducteur électrique sur une cellule photovoltaïque par un procédé à forte productivité, performant et économique.

L'invention est plus particulièrement définie par les revendications.

Ces objets, caractéristiques et avantages de la présente invention seront exposés en détail dans la description suivante de modes d'exécution particuliers faits à titre non-limitatif en relation avec les figures jointes parmi lesquelles :
La figure 1 illustre schématiquement les conducteurs à la surface d'une cellule photovoltaïque selon l'état de la technique.
La figure 2 représente schématiquement une partie des conducteurs à la surface d'une cellule photovoltaïque selon un premier mode d'exécution de l'invention.
La figure 3a représente une zone agrandie dite zone d'interconnexion des conducteurs à la surface d'une cellule photovoltaïque selon le premier mode d'exécution de l'invention.
La figure 3b représente une zone agrandie de la zone d'interconnexion des conducteurs à la surface d'une cellule photovoltaïque selon une variante du premier mode d'exécution de l'invention.
Les figures 4 à 7 illustrent schématiquement la zone d'interconnexion des conducteurs à la surface d'une cellule photovoltaïque respectivement selon quatre variantes du premier mode d'exécution de l'invention.
Les figures 8 à 10 illustrent schématiquement la zone d'interconnexion des conducteurs à la surface d'une cellule photovoltaïque selon différentes phases d'impression selon un exemple ne faisant pas partie de l'invention.
La figure 11 représente schématiquement une vue en coupe au niveau d'un bus d'une cellule photovoltaïque selon un premier mode d'exécution de l'invention.
La figure 12 représente un procédé de préformage d'un ruban métallique par poinçonnage.
La figure 13 représente un procédé de préformage d'un ruban métallique par embossage.
La figure 14 représente un ruban métallique préformé selon l'invention en vue de dessus.
La figure 15 représente une plaque en vue de dessus selon un mode d'exécution de l'invention.
La figure 16 représente une plaque en coupe de côté selon un mode d'exécution de l'invention.
La figure 17 représente une plaque en coupe de côté selon une variante du mode d'exécution de l'invention.
Les figures 18 à 20 illustrent trois exemples de section de tresse métallique multibrins selon un mode d'exécution de l'invention.
La figure 21 illustre schématiquement la soudure d'une tresse sur une cellule photovoltaïque selon un mode d'exécution de l'invention.
La figure 22 représente un dispositif pour la soudure d'une tresse sur une cellule photovoltaïque selon un mode d'exécution de l'invention.
Les figures 23 à 25 représentent trois variante de thermodes d'un dispositif pour la soudure d'une tresse sur une cellule photovoltaïque selon un mode d'exécution de l'invention.

L'invention permet l'utilisation particulière du procédé dit « de Stencil », puisqu'utilisant un pochoir de type stencil, permettant d'obtenir les conducteurs électriques à la surface d'une cellule photovoltaïque en une seule étape d'impression. Ainsi, l'invention présente le double avantage de pouvoir obtenir des conducteurs réguliers en épaisseur et performants grâce au procédé de Stencil, tout en restant économique. Pour cela, l'invention repose sur le concept de réalisation de conducteurs non continus, présentant avantageusement des géométries particulières au niveau de leurs zones discontinues pour permettre de garantir une future connexion électrique performante et une tenue mécanique suffisante.

L'invention définit en fait une géométrie des conducteurs qui représente un compromis optimal entre le fait d'obtenir des conducteurs de géométrie présentant une grande performance électrique et mécanique et le fait de réaliser des ouvertures pas trop importantes dans le feuillard métallique utilisé pour rester compatible avec le procédé d'impression par stencil.

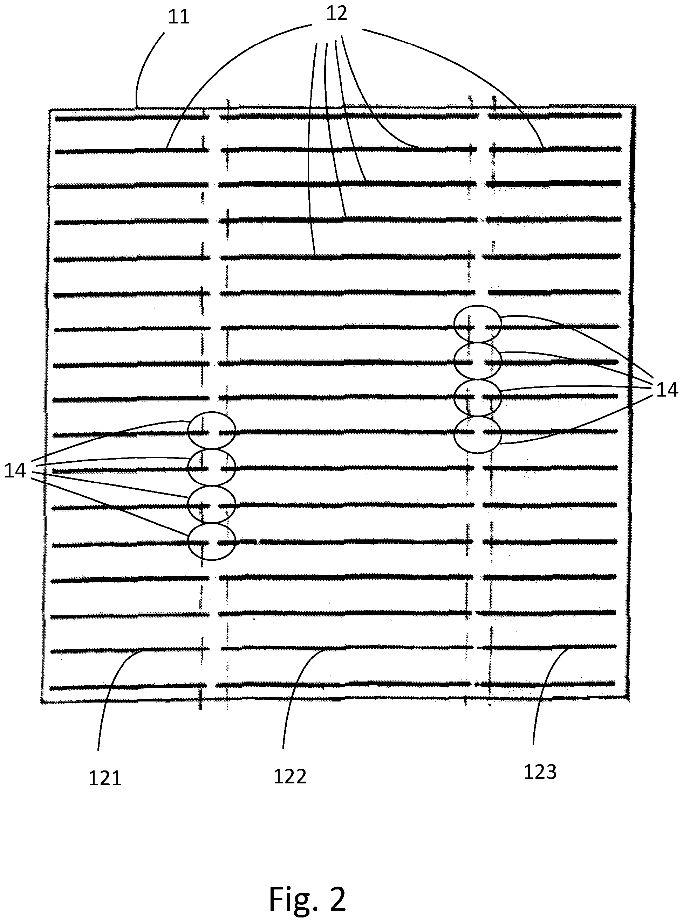

La figure 2 représente un premier mode d'exécution de l'invention dans lequel chaque conducteur de collecte 12, obtenu par impression stencil, est discontinu, se compose en fait de trois segments distincts 121, 122, 123 sensiblement alignés pour s'étendre sur toute la largeur de la plaque 11. Ces segments 121, 122, 123 peuvent avoir une largeur de 0,07 à 0,12 mm, voire inférieure à 0,07 mm, de l'ordre de 0,03 à 0,06 mm pour les cellules de haute performance. Cette multitude de conducteurs de collecte 12 parallèles, qui forme des premiers conducteurs 12, définit ainsi des zones dites d'interconnexion 14, au niveau desquelles les conducteurs 12 sont interrompus, entre deux segments 121, 122 et 122, 123. Ces différentes zones d'interconnexion 14 des différents conducteurs de collecte 12 sont alignées selon une direction différente de celle des conducteurs de collecte 12, sensiblement perpendiculaire aux conducteurs de collecte 12, afin de permettre leur liaison électrique à l'aide d'au moins un second conducteur, par exemple d'un ruban de cuivre non représenté qui sera décrit ultérieurement, les recouvrant pour les relier électriquement et formant finalement un conducteur perpendiculaire correspond aux conducteurs 3 visibles sur la figure 1.

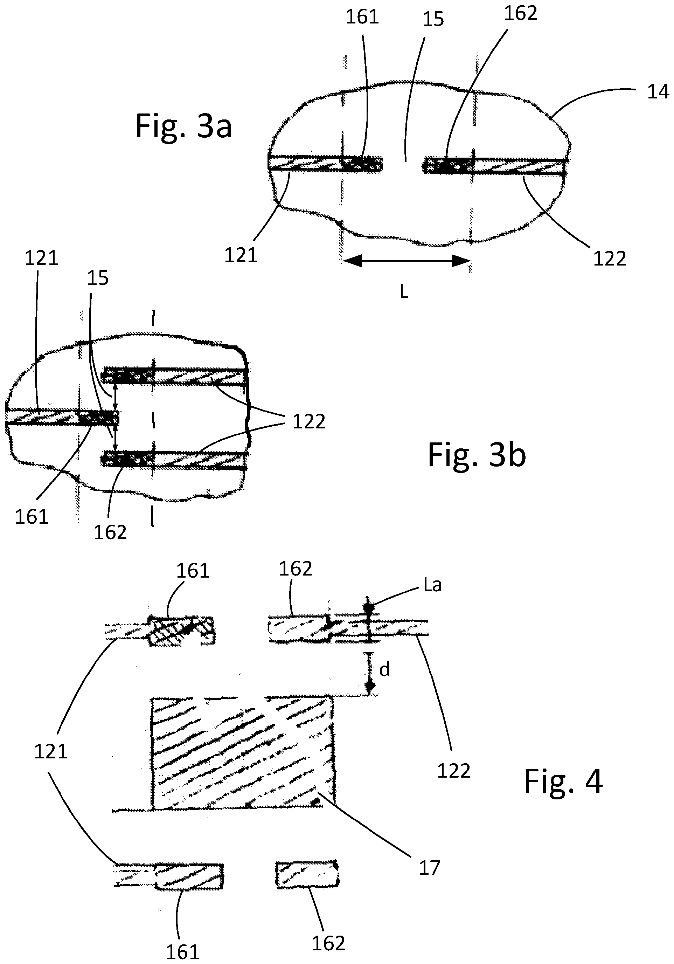

La figure 3a représente plus particulièrement une zone d'interconnexion 14 entre deux segments 121, 122 d'un conducteur de collecte 12. Chaque segment 121, 122 présente respectivement une extrémité 161, 162 se faisant face, ces deux extrémités étant séparées par un espacement 15. Ces extrémités représentent des connecteurs électriques. En effet, ils sont destinés à être recouverts par un ruban métallique, par exemple en cuivre, de largeur L, qui recouvre toute la largeur L de la zone d'interconnexion 14 et effectue une liaison électrique entre les deux segments 121, 122 au niveau de l'interconnexion 14, ainsi qu'une liaison électrique entre les différents conducteurs de collecte 12 en s'étendant sur toute la longueur de la plaque 11. Naturellement, les zones d'interconnexion 14 entre les segments 122, 123 des conducteurs de collecte 12 présentent la même géométrie, et sont de même destinées à être reliées électriquement par un second ruban métallique. L'espace 15 doit être suffisant pour préserver la rigidité du masque d'impression utilisé : pour cela, il est d'au moins 0,25 mm, par exemple de préférence égal à 0,5 mm.

La figure 3b représente une variante de réalisation dans laquelle les différents segments 121, 122 sont décalés et non alignés, de sorte d'être séparés par un espacement 15 d'au moins 2 mm dans une direction perpendiculaire aux segments.

La figure 4 illustre une première variante de réalisation d'une zone d'interconnexion 14, dans laquelle chaque segment 121, 122 présente des connecteurs électriques 161, 162 de géométrie particulière à son extrémité, de plus grande dimension que les conducteurs 121, 122. En effet, chaque connecteur électrique présente une largeur La plus importante, de l'ordre de 0,2 mm, pour finalement former une géométrie sensiblement rectangulaire, de longueur égale à environ 0,65 mm et de largeur égale à 0,2 mm.

De plus, cette première variante d'exécution comprend des plages métallisées supplémentaires 17, prévues entre les connecteurs électriques 161, 162 et entre deux conducteurs de collecte 12 parallèles et juxtaposés, dont la fonction est d'apporter une tenue mécanique renforcée au niveau des zones d'interconnexion 14, sans aucun rôle électrique. Ainsi, les zones métallisées 161, 162, 17 prévues dans les zones d'interconnexion 14 présentent une surface suffisante pour supporter les contraintes d'assemblage, supporter les contraintes subies lors du fonctionnement de la cellule photovoltaïque, comme les contraintes de dilatation différentielle des divers matériaux.

Les connecteurs électriques 161, 162 présentent une surface suffisante pour assurer la liaison électrique entre les différents segments 121, 122 des conducteurs de collecte 12. Pour conserver l'intégrité mécanique du feuillard métallique de type stencil utilisé lors de la réalisation de ces dépôts métalliques sur la surface de la plaque 11, en une seule opération, les plages métallisées supplémentaires 17 sont séparées des connecteurs électriques d'une distance d supérieure à 0,25 mm, de préférence de l'ordre de 0,5 mm.

Bien entendu, les connecteurs électriques et les plages métallisées supplémentaires peuvent présenter de nombreuses autres formes et dimensions différentes sans sortir du concept de l'invention. Notamment, ces formes et dimensions peuvent avantageusement être adaptées au type de liaison choisi pour fixer le ruban métallique sur leur surface.

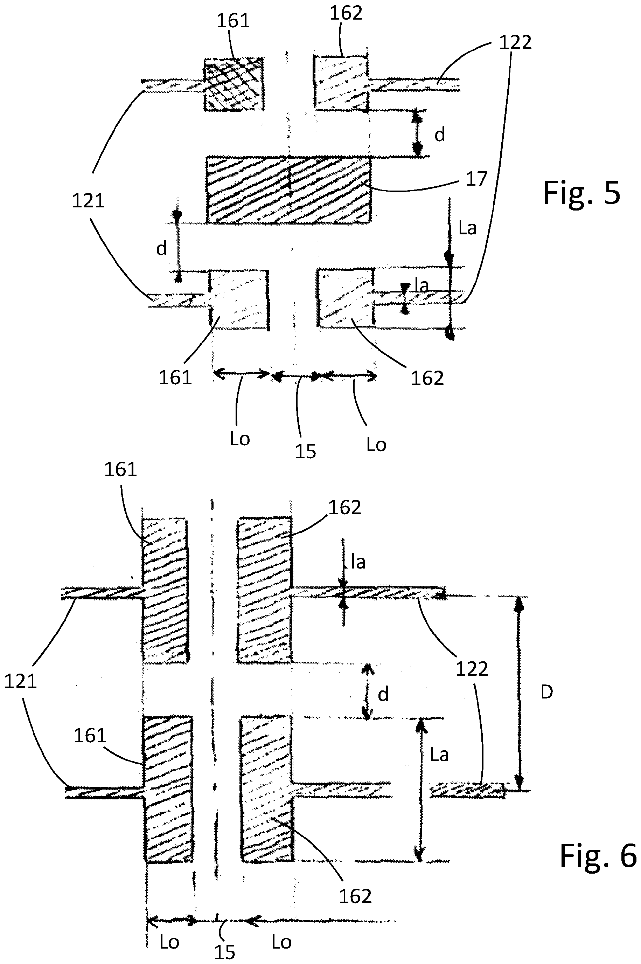

La figure 5 illustre une seconde variante de réalisation, dans laquelle les connecteurs électriques 161, 162 présentent une surface plus importante, rectangulaire de largeur La de l'ordre de 0,5 mm et de longueur Lo de l'ordre de 0,65 mm. Ces connecteurs électriques 161, 162 restent espacés par un espace 15 de l'ordre de 0,5 mm. De plus, la plage métallisée 17 intermédiaire présente une surface réduite, pour rester à une distance d d'au moins 0,25 mm, de l'ordre de 0,5 mm préférentiellement, des connecteurs électriques 161, 162, toujours pour préserver la rigidité du masque utilisé. Les segments conducteurs 121, 122 présentent une largeur la de 0,07 mm.

Les deux variantes de réalisation relatives aux figures 4 et 5 sont bien adaptées à la fixation d'un ruban métallique par soudure, par nature très peu résistive.

La figure 6 illustre une troisième variante de réalisation, particulièrement adaptée à la fixation d'un ruban métallique par collage, à l'aide d'une colle conductrice. Dans cette variante, les connecteurs électriques 161, 162 présentent une surface nettement supérieure pour compenser la résistance due à la colle. Pour cela, ils présentent une forme rectangulaire allongée dans la direction perpendiculaire aux conducteurs de collecte 12, de dimension d'environ 0,65 mm (Lo) par 1,5 mm (La). Les extrémités de ces connecteurs électriques 161, 162 de deux segments 121, 122 de conducteurs de collecte parallèles et juxtaposés restent séparées d'une distance d d'au moins 0,25 mm, 0,5 mm dans cette réalisation, pour préserver la rigidité mécanique du feuillard utilisé pour leur réalisation. L'espace 15 reste de même de l'ordre de 0,5 mm. Les conducteurs 121, 122 présentent une largeur de 0,07 mm et deux conducteurs de collecte 12 parallèles sont espacés d'une distance D de l'ordre de 2,1 mm.

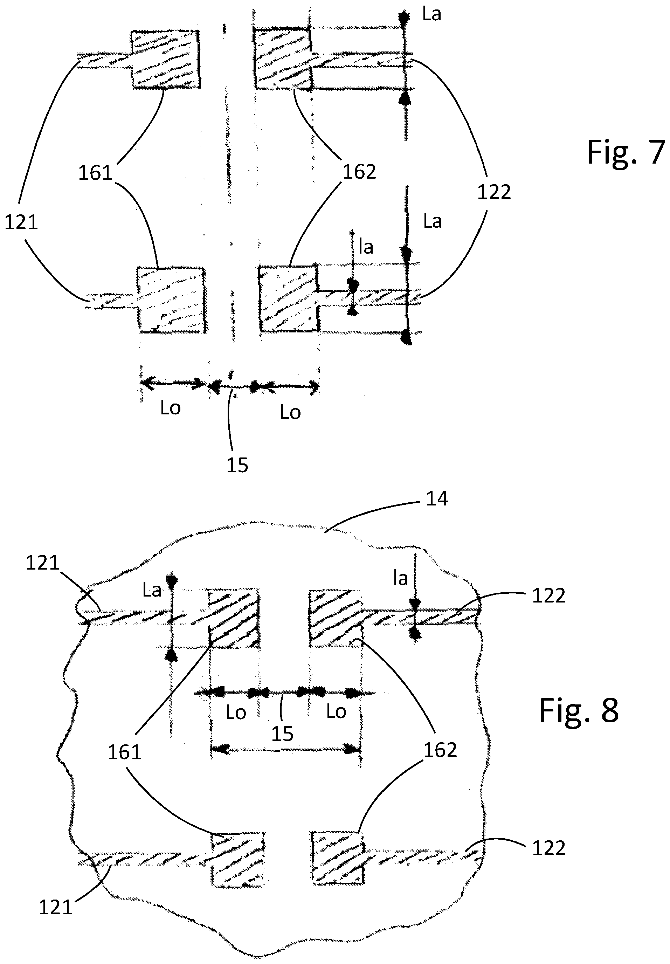

Dans la quatrième variante de réalisation représentée sur la figure 7, les connecteurs électriques présentent une forme rectangulaire de dimension réduite de 0,65 mm par 0,70 mm. La distance entre deux connecteurs électriques 161, 162 de deux segments différents alignés est de même supérieure à 0,25 mm, de l'ordre de 0,50 mm.

Dans cette géométrie des connecteurs électriques 161, 162 des deux dernières variantes de réalisation, il n'y a pas besoin d'ajouter des plages métallisées supplémentaires 17, les connecteurs électriques 161, 162 présentent une surface suffisante pour répondre à la double exigence électrique et mécanique. La variante de la figure 7 propose une surface des connecteurs électriques inférieure à celle des connecteurs électriques de la variante de la figure 6. Elle sera privilégiée dans des cas où une colle particulière est utilisée, offrant une adhésion différente sur les zones métallisées et non métallisées, et notamment une meilleure adhérence sur les zones non métallisées.

Naturellement, toute autre fixation que la soudure ou le collage pourrait en variante être utilisée pour la fixation d'un ruban métallique de type ruban en cuivre pour recouvrir les zones d'interconnexion. De plus, en variante, tout autre élément conducteur qu'un ruban métallique pourrait être utilisé pour réaliser la connexion électrique au niveau des zones d'interconnexion, c'est-à-dire de discontinuité des conducteurs réalisés, comme la réalisation de conducteurs supplémentaires par sérigraphie avec un écran ou par une étape supplémentaire de stencil, ou à l'aide d'une plaque métallisée, ou toute autre méthode sans contact comme le jet d'encre.

Les figures 8 à 10 illustrent un exemple ne faisant pas partie de l'invention dans lequel les conducteurs 12 sont formés par deux étapes complémentaires d'impression à base de deux pochoirs différents de type stencil. Dans ce mode d'exécution particulier, la seconde étape d'impression comble les absences de métallisation de la première impression.

La figure 8 représente ainsi plus précisément la géométrie obtenue par la première impression à l'aide d'un premier stencil, dans laquelle les segments de conducteurs 121, 122 réalisés présentent des connecteurs électriques 161, 162 élargis sur leurs extrémités se faisant face, non connectés entre eux. Dans cette réalisation, les connecteurs électriques présentent une largeur La de 0,5 mm pour une longueur de 0,45 mm. Ils sont espacés par un espace 15 de 0,45 mm. Cette première impression est similaire à l'impression réalisée dans le premier mode d'exécution de l'invention.

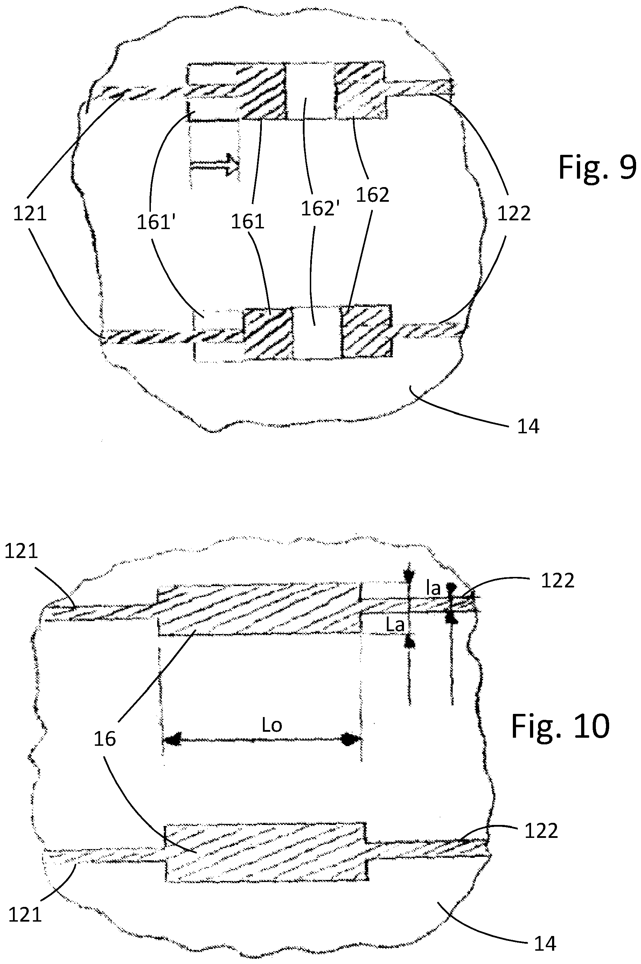

La figure 9 représente l'impression réalisée par la seconde étape d'impression, qui présente un décalage au niveau de la zone d'interconnexion 14, de l'ordre de 0,45 mm, pour former des surfaces 161', 162' de sorte de former finalement une métallisation continue 16 dans la direction des conducteurs 121, 122, présentant une longueur totale Lo de 1,8 mm et de 0,5 mm de large (La), représentée sur la figure 10. Ces métallisations des zones d'interconnexion 14 sont ensuite reliées entre elles par tout moyen électrique, comme par exemple un ruban métallique tel qu'explicité précédemment. En remarque, ces métallisations restent discontinues dans une direction verticale.

Cette double impression peut aussi être utilisée pour la réalisation des conducteurs de collecte 121, 122. En effet, ces conducteurs peuvent être réalisés par une succession de segments réalisés alternativement par la première et par la seconde impression en préservant une zone de recouvrement pour assurer leur continuité électrique. Cela permet d'augmenter la rigidité des masques d'impression, chaque masque présentant ainsi des ouvertures moins longues, espacées toutefois d'une distance minimale.

Bien entendu, l'invention ne se limite pas aux formes représentées pour les connecteurs électriques aux extrémités discontinues des premiers conducteurs, les segments conducteurs, et plages métallisées supplémentaires. Notamment, ces dernières peuvent présenter toute autre forme que rectangulaire, et peuvent se présenter sous forme d'association de plusieurs surfaces distinctes complémentaires, disposées entre chaque conducteur de collecte. Les connecteurs électriques pourraient présenter d'autres dimensions, avantageusement une largeur supérieure ou égale à 0,2 mm et/ou une longueur supérieure ou égale à 0,4 mm, et d'autres formes, non nécessairement rectangulaires. Les extrémités des conducteurs de collecte 121, 122 pourraient s'élargir progressivement pour atteindre la largeur des connecteurs électriques 161, 162 mentionnée ci-dessus. Selon une variante représentée sur la figure 3a, les connecteurs électriques peuvent même présenter une largeur similaire, voire identique, à celle des segments conducteurs. Ces derniers sont les conducteurs de collecte dans les exemples décrits précédemment. Toutefois, l'invention reste applicable à d'autres types de conducteurs. De plus, ces conducteurs peuvent présenter d'autres formes, non nécessairement rectilignes et tout autre nombre de discontinuités.

L'invention a été décrite pour la réalisation de conducteurs à la surface d'une cellule photovoltaïque. Elle est particulièrement adaptée aux conducteurs présentant des formes en H, c'est-à-dire comprenant plusieurs conducteurs différents reliés entre eux et présentant des directions sensiblement perpendiculaires. Elle est compatible avec toutes cellules, notamment les cellules HET sur lesquelles on trouve des métallisations déposées sur un oxyde transparent conducteur.

L'invention porte aussi sur un procédé de réalisation d'une conduction électrique sur une plaque à l'aide d'un pochoir métallique de type stencil, caractérisé en ce qu'il comprend les étapes suivantes :
- réalisation d'une impression au travers le pochoir pour déposer une couche d'encre conductrice sur la surface de la plaque, de sorte de former plusieurs premiers conducteurs selon une première direction, ces conducteurs étant discontinus, interrompus au niveau d'au moins une zone d'interconnexion,
- réalisation d'une liaison électrique en recouvrant les zones d'interconnexion des premiers conducteurs par au moins un second conducteur.

Cette dernière étape est avantageusement obtenue par la fixation d'un ruban métallique par soudure ou collage. En remarque, les modes de réalisation précédents ont été décrits à l'aide d'un ruban ou tresse remplissant la fonction de second conducteur, directement fixé sur les conducteurs de collecte tels que décrits en détail ci-dessus. En variante toutefois, il est envisageable de réaliser des seconds conducteurs 3 par sérigraphie, de la même manière que dans l'état de la technique, puis d'ajouter un ruban 13 ou tresse sur ces seconds conducteurs.

De plus, l'invention porte aussi sur un procédé de fabrication d'une cellule photovoltaïque caractérisé en ce qu'il comprend la réalisation d'une conduction électrique sur une plaque par le procédé explicité ci-dessus. L'invention permet ainsi la formation de modules photovoltaïques par la liaison de plusieurs cellules photovoltaïques ainsi obtenues, ainsi que la fabrication de centrales photovoltaïques de production d'électricité regroupant de tels modules photovoltaïques.

La solution de l'invention présente finalement les avantages suivants :
- l'utilisation d'une impression par un procédé de type stencil permet d'obtenir des conducteurs d'épaisseur importante, présentant un rapport épaisseur/largeur élevé et régulier, ce qui garantit leur bonne performance électrique ;
- elle est adaptée à la réalisation des conducteurs par une seule impression stencil, ce qui est économique et rapide ;
- elle réduit la quantité d'encre utilisée, qui peut être de l'argent, et réduit ainsi le coût global.

Le second aspect de l'invention concerne le ruban 13 ou tresse ajouté(e) sur la cellule photovoltaïque, dans une direction sensiblement perpendiculaire aux conducteurs de collecte décrits ci-dessus.

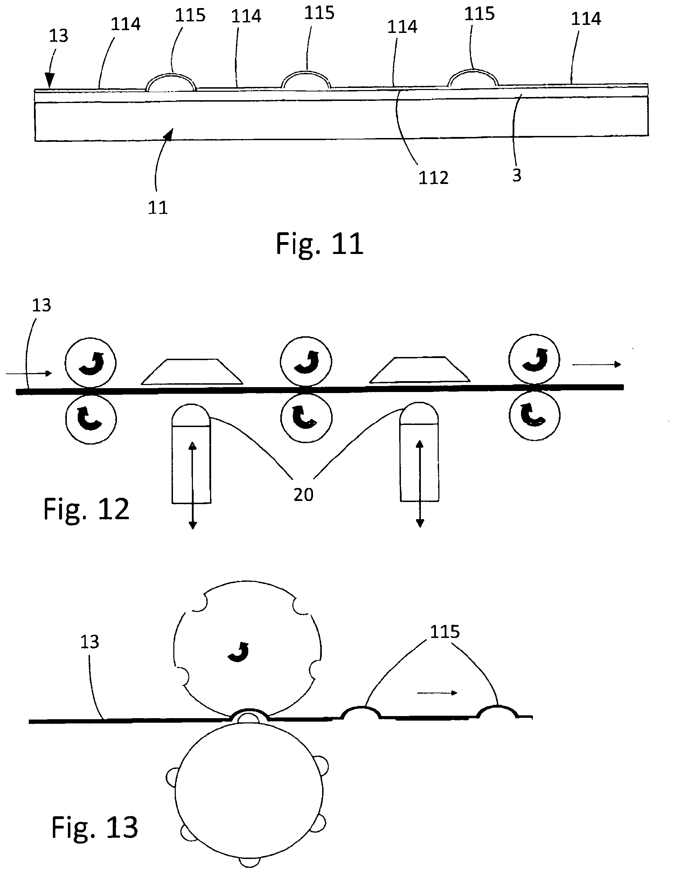

La figure 11 représente la structure d'une cellule photovoltaïque en coupe selon un mode d'exécution de l'invention, plus particulièrement pour illustrer la fixation du ruban 13 de cuivre destiné à conduire les charges électriques. Ce ruban 13 est discontinu, présente une alternance entre des zones de fixation 114, qui comprennent les zones d'interconnexion 14 dans cette réalisation, pour lesquelles il est connecté à un bus 3 de la cellule, et des zones de non connexion 115 pour lesquelles il n'est pas fixé sur la cellule. En remarque, ce bus 3 est facultatif, comme cela a été envisagé ci-dessus. De plus, les zones de fixation 114 du ruban 13 sur la cellule correspondent de préférence aux zones d'interconnexion 14 définies précédemment par la position des conducteurs de collecte. Ces zones de fixation 114 peuvent toutefois s'étendre au-delà de cette zone d'interconnexion 14. De plus, dans le cas particulier d'ajout d'un bus 3 distinct intermédiaire, comme représenté, ces zones de fixation 114 pourraient en variante ne pas correspondre aux zones d'interconnexion 14. Cette géométrie permet de réduire les contraintes résiduelles dans les zones de fixation 114 du ruban 13 sur la cellule, en réduisant les longueurs de connexion. En remarque, ce ruban recouvre donc un bus conducteur 3, et est fixé à ce bus 3 par tout moyen de fixation conducteur 112. Cet ensemble est monté sur une plaque 11 de la cellule photovoltaïque. Le ruban choisi est un ruban en cuivre : tout autre ruban 13 métallique pourrait en variante être utilisé.

Avantageusement, la longueur des zones de fixation 114 est inférieure à 15 mm, voire même inférieure à 5 mm, pour obtenir une réduction significative des contraintes de dilatation sur l'interface. Ces zones de fixation 114 sont alors multiples et de faible longueur.

D'autre part, les zones de non connexion 115 du ruban 13 présentent avantageusement une longueur plus grande que la distance entre deux zones de fixation 114 successives l'entourant, pour favoriser la déformation des portions de cuivre non reliées à la cellule et offrir une meilleure adaptation aux phénomènes de dilatation.

En remarque, cette présence de longueur de ruban 13 allongée sur la cellule photovoltaïque va à l'encontre des habitudes de l'homme du métier parce que cela implique une complexité accrue de l'alignement, de façon plus générale de la fabrication, et cela entraîne un surcoût.

Pour permettre au ruban 13 une configuration qui lui permet de se dilater au mieux ou de se rétracter au mieux sur les zones 115 non fixées à la cellule, avec un minimum de contrainte, il est intéressant d'utiliser une bande de cuivre préformée ou une tresse de cuivre. Cette dernière solution sera décrite plus en détail ultérieurement.

La figure 12 illustre un premier procédé pour préformer ou onduler le ruban de cuivre, à l'aide d'un matriçage composé de poinçons 20 espacés en fonction du pas choisi pour les zones 115. En variante, la figure 13 illustre la réalisation de ce préformage par embossage, pour former les zones 115 embossées. Ces étapes préalables permettent de former un ruban ondulé dans l'épaisseur, c'est-à-dire dans une direction verticale, perpendiculaire au plan de la plaque 11, comme cela est visible sur la figure 11.

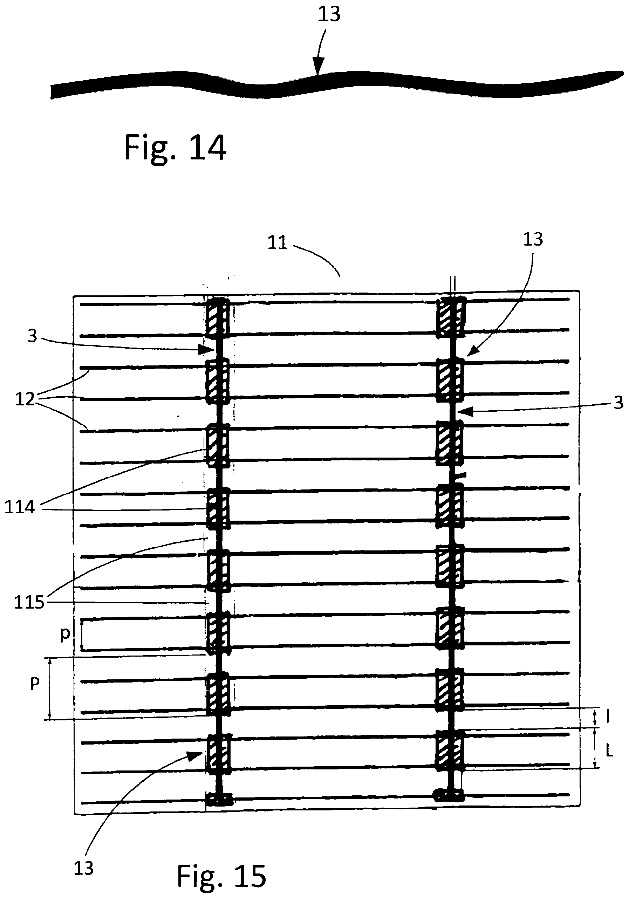

En remarque, le ruban peut aussi être ondulé selon une autre direction, comme une direction latérale, dans le plan de la plaque 11, comme cela est représenté sur la figure 14.

La fixation du ruban métallique a été obtenue par un moyen de fixation 112 qui peut être une soudure. En variante, il est possible d'utiliser un adhésif conducteur et un ruban de cuivre non revêtu d'un alliage fusible à la température de polymérisation. L'utilisation d'un adhésif permet de localiser la zone d'interconnexion. De plus, ce type de connexion est plus souple que par exemple une soudure.

Avantageusement, les zones de fixation 114 sont positionnées par rapport aux conducteurs de la cellule photovoltaïque de sorte d'optimiser la performance électrique de la solution. Pour cela, il est prévu de limiter le cheminement des charges électriques dans les conducteurs de plus grande résistance que le ruban 13 de cuivre, c'est-à-dire de faire en sorte de ne pas allonger le parcours de ces charges dans les conducteurs de la cellule.

La solution préférée consiste ainsi à positionner les zones de fixation 114 au-dessus des conducteurs de collecte 12, comme cela a été vu précédemment, de manière correspondante aux zones d'interconnexions 14. Comme ces conducteurs de collecte 12 sont en général parallèles et espacés d'un pas constant p, les zones de fixation 114 peuvent être réparties sur le ruban 13 selon un pas P constant pour correspondre aux conducteurs de collecte 12.

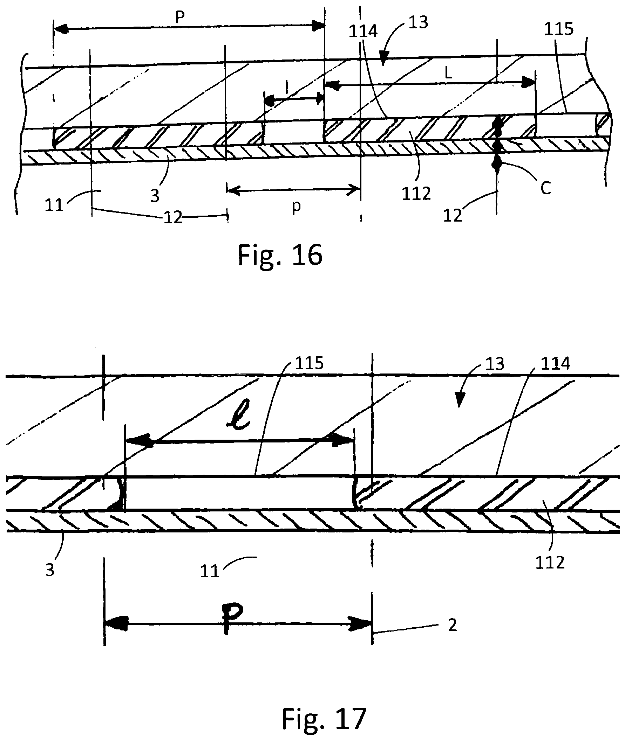

Les figures 15 et 16 illustrent ainsi un exemple de réalisation avantageux, sur une plaque 11 comprenant des conducteurs de collecte 12 répartis selon un pas p, et deux bus perpendiculaires 3, selon une géométrie habituelle telle que présentée à la figure 1. Ces deux bus 3 sont recouverts d'un ruban 13 métallique selon l'invention. Les zones de fixation 114 de ce ruban sont séparées selon un pas P multiple de p, de sorte que tous les conducteurs de collecte 12 sont situés sous une zone de fixation 114 au niveau des bus 3, pour favoriser ainsi le transfert des charges électriques C des conducteurs de collecte 12 vers le ruban métallique 13 au travers du moyen de fixation 112 conducteur. Avantageusement, le pas P des zones de fixation peut être identique à celui des conducteurs de collecte. En remarque, ce pas P correspond à la somme de la longueur L d'une zone de fixation 114 et de la longueur I entre deux zones de fixation 114.

En remarque, la distance I entre deux zones de fixation 114 du ruban 13 sur la plaque 11 ne doit pas être trop petite, pour permettre la déformation suffisante du ruban, et pas trop grande pour permettre de s'adapter à la séparation entre les conducteurs de collecte 12 selon le principe explicité ci-dessus. Un compromis avantageux peut consister à prendre cette longueur I égale ou proche du pas p des conducteurs de collecte 12, comprise dans une fourchette p-20%p ≤ I ≤ p, comme cela est représenté sur la figure 17.

Naturellement, l'invention peut aussi être implémentée avec un ruban présentant des zones de fixation 114 différentes entre elles, par exemple de longueur L différente, et des zones de non connexion 115 de longueur l différente.

L'invention a été décrite pour la fixation avantageuse d'un ruban métallique, de préférence en cuivre, sur les conducteurs d'une cellule photovoltaïque. Elle s'adapte à tous conducteurs, même différents des conducteurs de structure présentée en référence à la figure 1 des solutions de l'état de la technique. De tels conducteurs peuvent être formés par toute technique de l'état de la technique, notamment par impression d'une encre conductrice par un procédé sérigraphique ou avec un pochoir de type stencil.

Notamment, l'invention peut être implémentée sur un dispositif photovoltaïque comprenant une plaque, comprenant plusieurs premiers conducteurs orientés selon une première direction, ces premiers conducteurs étant discontinus, comme décrits précédemment, et comprenant au moins un ruban 13 selon l'invention réalisant la connexion électrique des premiers conducteurs entre eux au niveau des zones discontinues, sans présence d'un bus ou autre conducteur intermédiaire. Ces dernières zones discontinues peuvent être alignées selon une seconde direction différente de la première direction, de sorte que le ruban 13 s'étend d'une extrémité à l'autre de la plaque selon cette seconde direction en reliant électriquement les zones discontinues des différents premiers conducteurs.

L'invention porte aussi sur un procédé de réalisation de conducteurs électriques sur une plaque 11 d'un dispositif photovoltaïque tel que décrit précédemment, qui comprend les étapes suivantes :
- réalisation d'une impression pour déposer une couche d'encre conductrice sur la surface de la plaque 11, de sorte de former plusieurs conducteurs électriques,
- fixation d'un ruban métallique de type en cuivre sur au moins un conducteur électrique, ce ruban métallique comprenant des zones de fixation 114 pour lesquelles il est mécaniquement et électriquement connecté au conducteur électrique et des zones de non connexion 115 pour lesquelles il est mécaniquement non lié au conducteur électrique.

Le procédé comprend avantageusement une étape préalable de préformage du ruban métallique par un outil de type poinçons ou par embossage comme explicité précédemment.

De plus, l'invention porte aussi sur un procédé de fabrication d'une cellule photovoltaïque caractérisé en ce qu'il comprend la réalisation d'une conduction électrique sur une plaque par le procédé explicité ci-dessus. L'invention a été décrite pour une implémentation sur les conducteurs de collecte d'une cellule photovoltaïque, et plus particulièrement pour la connexion de plusieurs rubans métalliques sur chaque bus de la cellule, soit en général deux ou trois bus. Elle est aussi applicable si les bus sont sous forme de plaques. En variante, elle reste applicable à toute structure de cellule photovoltaïque, pour tous conducteurs électriques, ainsi que pour tout type de cellules photovoltaïques, plus particulièrement pour tout dispositif photovoltaïque.

Les rubans métalliques ainsi connectés servent de plus à relier les différentes cellules photovoltaïques entre elles, par la continuité des rubans ou par soudure de l'extrémité de ces rubans, pour former des modules photovoltaïques, puis des centrales de production photovoltaïque.

En remarque, les modes de réalisation décrits ci-dessus utilisent un ruban. Ce dernier se présente par exemple sous la forme d'une bande de section de 1,5 à 2 mm de large sur 0,2 mm d'épaisseur. Cette géométrie conserve toutefois une certaine rigidité qui peut induire des contraintes trop importantes lors d'effets de dilatation dans certaines géométries particulières de cellules photovoltaïques et/ou d'utilisations particulières. Pour répondre à ce problème technique, une solution consiste à utiliser une tresse métallique, par exemple une tresse de cuivre.

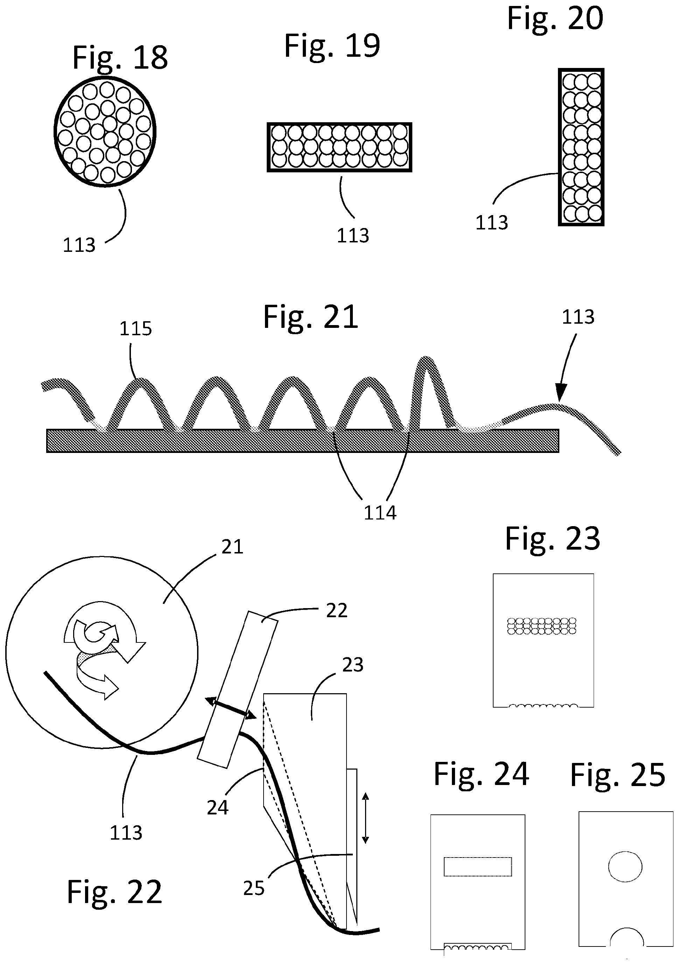

Les figures 18 à 20 illustrent ainsi à titre d'exemple la section de trois tresses 113, qui sont des câbles électriques multibrins, se composent d'une multitude de brins conducteurs de petite section, dont la section conductrice globale reste équivalente à celle d'un ruban. Ainsi, une telle tresse 113 présente une conductivité équivalente à celle d'un ruban 13 mais une plus grande souplesse.

Cette souplesse peut de plus être choisie :
- le diamètre des brins est un premier facteur important, la souplesse étant d'autant plus grande que ce diamètre est petit. Il est par exemple possible de prendre un diamètre de 0,15 mm pour obtenir une grande souplesse ;
- de plus, la répartition des brins dans la section de la tresse permet de privilégier certains axes de souplesse. La tresse de la figure 18 présente une souplesse multidirectionnelle, celle de la figure 19 une souplesse verticale et celle de la figure 20 une souplesse horizontale.

La fixation d'une telle tresse sur une cellule photovoltaïque peut se faire par collage ou soudure sur les zones de fixation 114, comme décrit précédemment.

Dans le cas d'une soudure, il faut garantir un contact suffisant entre le métal d'apport pour réaliser la soudure, comme l'étain, et tous les brins, pour éviter qu'un ou plusieurs brin(s) reste(nt) électriquement isolé(s). En même temps, il ne faut pas exagérer la quantité d'étain apportée pour ne pas trop rigidifier la tresse. Pour atteindre un bon compromis, un procédé de fixation par soudure d'une tresse comprend une étape d'augmentation de la soudabilité de la tresse dans les seules zones de fixation. Pour cela, une solution consiste à désoxyder le cuivre des brins uniquement dans les zones de fixation 114, juste avant la soudure, pour favoriser la soudure de ces zones alors que les autres zones restent beaucoup moins adaptées à leur soudure. Cette désoxydation peut se faire avec un flux liquide déposé par exemple avec une seringue ou par tamponnage.

Ce procédé de fixation peut comprendre une étape préalable de retrait d'une protection, comme un vernis, ou de dénudement des brins de cuivre dans les zones de fixation 114, pour obtenir la configuration illustrée par la figure 21.

De plus, pour favoriser encore plus l'efficacité électrique de la soudure, la tresse, ou du moins ses parties dans les zones de fixation, peut être pré-étamée par trempage dans un bain d'étain liquide ou par électrolyse avant la soudure à base d'étain en tant que telle.

La figure 22 illustre un dispositif permettant de réaliser automatiquement et facilement la soudure d'une tresse 113 sur une cellule photovoltaïque. Ce dispositif comprend un dérouleur de fil 21, une pince 22 pour casser le fil, une thermode 23 comprenant un guide-fil 24 puis un couteau 25 pour couper le fil. Un tel dispositif peut traiter les différents brins de la tresse séparément. Dans un tel cas, la thermode comprend une forme représentée sur la figure 23. En variante, lorsque la tresse comprend une enveloppe plastique, la thermode est adaptée à la géométrie de la tresse, et sa section peut être comme représentée en figure 24 pour une tresse gainée rectangulaire, ou comme représentée en figure 25 pour une tresse gainée circulaire.

## Revendications

1. Dispositif photovoltaïque comprenant une plaque (11), **caractérisé en ce qu'**il comprend plusieurs premiers conducteurs (12) orientés selon une première direction, discontinus, interrompus au niveau de zones d'interconnexion (14), et **en ce qu'**au moins un second conducteur (13 ; 113) réalise la connexion électrique des premiers conducteurs (12) entre eux au niveau des zones d'interconnexion (14), et **en ce qu'**il est fixé sur au moins un premier conducteur électrique (12) et comprend des zones de fixation (114) pour lesquelles il est mécaniquement et électriquement connecté à un premier conducteur électrique (12) et des zones de non connexion (115) pour lesquelles il est mécaniquement non lié à un conducteur électrique, de sorte à être ainsi connecté de manière discontinue aux premiers conducteurs électriques (12), et le au moins un second conducteur étant un ruban métallique (13), comme un ruban en cuivre, ou une tresse (113), qui recouvre les deux extrémités d'un premier conducteur (12) au niveau d'une discontinuité sur une zone d'interconnexion (14) et qui recouvre plusieurs zones d'interconnexion (14), de sorte à relier électriquement plusieurs premiers conducteurs (12), ce au moins un ruban métallique (13) ou tresse (113) réalisant la connexion électrique des premiers conducteurs (12) entre eux au niveau de leurs zones discontinues.

2. Dispositif photovoltaïque selon la revendication précédente, **caractérisé en ce que** l'extrémité des premiers conducteurs (12) au niveau de leur partie discontinue d'une zone d'interconnexion (14) forme des connecteurs électriques (161, 162 ; 16) plus larges que la largeur des premiers conducteurs (12) hors des zones d'interconnexion (14), et **en ce que** des zones d'interconnexion (14) sont alignées selon une seconde direction différente de la première direction, de sorte que le second conducteur (13 ; 113) s'étend d'une extrémité à l'autre de la plaque (11) selon cette seconde direction en reliant les zones d'interconnexion alignées.

3. Dispositif photovoltaïque selon l'une des revendications précédentes, **caractérisé en ce que** chaque premier conducteur (12) se présente sous la forme de plusieurs segments alignés selon la première direction, présentant un espace (15) entre eux au niveau des zones d'interconnexion (14), cet espace (15) étant supérieur ou égal à 0,25 mm.

4. Dispositif photovoltaïque selon l'une des revendications précédentes, **caractérisé en ce que** chaque premier conducteur (12) présente une largeur inférieure à 0,12 mm hors des zones d'interconnexion (14).

5. Dispositif photovoltaïque selon l'une des revendications précédentes, **caractérisé en ce que** chaque premier conducteur (12) s'étend d'une extrémité à l'autre de la plaque (11) selon la première direction.

6. Dispositif photovoltaïque selon l'une des revendications précédentes, **caractérisé en ce qu'**il comprend des plages métallisées (17) supplémentaires au niveau des zones d'interconnexion (14), distinctes des premiers conducteurs (12), pour assurer la tenue mécanique du au moins un second conducteur.

7. Dispositif photovoltaïque selon l'une des revendications précédentes, **caractérisé en ce que** les premiers conducteurs (12) se présentent sous la forme d'une seule couche d'encre imprimée discontinue, ou sous la forme de deux couches d'encre imprimées superposées et discontinues dans la direction verticale.

8. Dispositif photovoltaïque selon l'une des revendications précédentes, **caractérisé en ce qu'**il comprend au moins une zone de non connexion (115) entre deux zones de fixation (114) et **en ce que** la longueur du ruban métallique (13) ou tresse (113) de la zone de non connexion (115) est supérieure à la distance (I) entre les deux zones de fixation (114).

9. Dispositif photovoltaïque selon l'une des revendications précédentes, **caractérisé en ce que** le ruban métallique (13) ou tresse (113) est fixé par un moyen de fixation (112) conducteur dans une zone de fixation (114), de type soudure ou un adhésif conducteur.

10. Dispositif photovoltaïque selon l'une des revendications précédentes, **caractérisé en ce que** le dispositif photovoltaïque est une cellule photovoltaïque et **en ce que** les premiers conducteurs (12) sont des conducteurs de collecte de la cellule photovoltaïque.

11. Dispositif photovoltaïque selon la revendication précédente, **caractérisé en ce qu'**il est une cellule photovoltaïque comprenant des conducteurs de collectes (12) parallèles séparés par un pas constant (p) et un ruban métallique (13) ou tresse (113) comprenant des zones de fixation (114) réparties selon un pas constant (P) et superposées aux conducteurs de collecte (12).

12. Dispositif photovoltaïque selon la revendication précédente, **caractérisé en ce que** les zones de fixation (114) sont réparties selon un pas (P) multiple entier du pas (p) des conducteurs de collecte (12).

13. Dispositif photovoltaïque selon la revendication 11 ou 12, **caractérisé en ce que** la distance (I) entre les deux zones d'interconnexion (14) est comprise dans une fourchette p-20%p ≤ I ≤ p, où p est le pas des conducteurs de collecte (12).

14. Procédé de réalisation de conducteurs électriques sur une plaque (11) d'un dispositif photovoltaïque, **caractérisé en ce qu'**il comprend les étapes suivantes :
- réalisation d'une impression au travers un pochoir métallique de type stencil pour déposer une couche d'encre conductrice sur la surface de la plaque (11), de sorte à former plusieurs premiers conducteurs (12) selon une première direction, ces conducteurs (12) étant discontinus, interrompus au niveau d'au moins une zone d'interconnexion (14),
- réalisation d'une liaison électrique en recouvrant les zones d'interconnexion (14) des premiers conducteurs (12) par la fixation d'au moins un second conducteur (13 ; 113) qui est un ruban métallique (13) ou tresse (113) sur au moins un premier conducteur électrique (12), ce ruban métallique (13) ou tresse (113) comprenant des zones de fixation (114) pour lesquelles il est mécaniquement et électriquement connecté à premier un conducteur électrique (12) et des zones de non connexion (115) pour lesquelles il est mécaniquement non lié à un conducteur électrique et ce ruban métallique (13) ou tresse (113) réalisant la connexion électrique des premiers conducteurs (12) entre eux au niveau de leurs zones discontinues.

## Patentansprüche

1. Photovoltaische Vorrichtung, die eine Platte (11) enthält, **dadurch gekennzeichnet, dass** sie mehrere erste Leiter (12) enthält, die in einer ersten Richtung orientiert sind, diskontinuierlich sind und auf Höhe von Verbindungszonen (14) unterbrochen sind, und dass wenigstens ein zweiter Leiter (13; 113) die elektrische Verbindung der ersten Leiter (12) untereinander auf Höhe der Verbindungszonen (14) herstellt, und dass sie an wenigstens einem ersten elektrischen Leiter (12) befestigt ist und Befestigungszonen (114) aufweist, für die sie mechanisch und elektrisch mit einem ersten elektrischen Leiter (12) verbunden ist, und Nichtverbindungszonen (115) aufweist, für die sie mechanisch nicht mit einem elektrischen Leiter verbunden ist, derart, dass sie somit diskontinuierlich mit den ersten elektrischen Leitern (12) verbunden ist, wobei der wenigstens eine zweite Leiter ein Metallband (13) wie etwa ein Kupferband oder eine Tresse (113) ist, das bzw. die die beiden Enden eines ersten Leiters (12) auf Höhe einer Diskontinuität bei einer Verbindungszone (14) bedeckt und mehrere Verbindungszonen (14) bedeckt, derart, dass mehrere erste Leiter (12) elektrisch verbunden werden, wobei dieses wenigstens eine Metallband (13) oder die Tresse (113) die elektrische Verbindung der ersten Leiter (12) untereinander auf Höhe ihrer diskontinuierlichen Zonen herstellt.

2. Photovoltaische Vorrichtung nach dem vorhergehenden Anspruch, **dadurch gekennzeichnet, dass** das Ende der ersten Leiter (12) auf Höhe ihres diskontinuierlichen Teils einer Verbindungszone (14) elektrische Leiter (161, 162; 16) bildet, die breiter sind als die Breite der ersten Leiter (12) außerhalb der Verbindungszonen (14), und dass Verbindungszonen (14) auf eine von der ersten Richtung verschiedene zweite Richtung ausgerichtet sind, derart, dass sich der zweite Leiter (13; 113) von einem Ende zum anderen Ende der Platte (11) in dieser zweiten Richtung erstreckt und dabei die ausgerichteten Verbindungszonen verbindet.

3. Photovoltaische Vorrichtung nach einem der vorhergehenden Ansprüche, **dadurch gekennzeichnet, dass** jeder erste Leiter (12) die Form mehrerer Segmente besitzt, die auf die erste Richtung ausgerichtet sind und zwischen sich auf Höhe der Verbindungszonen (14) einen Zwischenraum (15) aufweisen, wobei dieser Zwischenraum (15) größer oder gleich 0,25 mm ist.

4. Photovoltaische Vorrichtung nach einem der vorhergehenden Ansprüche, **dadurch gekennzeichnet, dass** jeder erste Leiter (12) außerhalb der Verbindungszonen (14) eine Breite von weniger als 0,12 mm aufweist.

5. Photovoltaische Vorrichtung nach einem der vorhergehenden Ansprüche, **dadurch gekennzeichnet, dass** sich jeder erste Leiter (12) von einem Ende zum anderen Ende der Platte (11) in der ersten Richtung erstreckt.

6. Photovoltaische Vorrichtung nach einem der vorhergehenden Ansprüche, **dadurch gekennzeichnet, dass** sie auf Höhe der Verbindungszonen (14) zusätzliche metallisierte Bereiche (17) aufweist, die von den ersten Leitern (12) verschieden sind, um die mechanische Widerstandsfähigkeit des wenigstens einen zweiten Leiters sicherzustellen.

7. Photovoltaische Vorrichtung nach einem der vorhergehenden Ansprüche, **dadurch gekennzeichnet, dass** die ersten Leiter (12) die Form einer einzigen diskontinuierlichen gedruckten Tintenschicht oder die Form von zwei überlagerten gedruckten Tintenschichten, die in vertikaler Richtung diskontinuierlich sind, aufweisen.

8. Photovoltaische Vorrichtung nach einem der vorhergehenden Ansprüche, **dadurch gekennzeichnet, dass** sie wenigstens eine Nichtverbindungszone (115) zwischen zwei Befestigungszonen (114) aufweist und dass die Länge des Metallbandes (13) oder der Tresse (113) der Nichtverbindungszone (115) größer als der Abstand (l) zwischen den beiden Befestigungszonen (114) ist.

9. Photovoltaische Vorrichtung nach einem der vorhergehenden Ansprüche, **dadurch gekennzeichnet, dass** das Metallband (13) oder die Tresse (113) durch ein leitendes Befestigungsmittel (112) in einer Befestigungszone (114) des Typs Schweißung oder leitender Klebstoff befestigt ist.

10. Photovoltaische Vorrichtung nach einem der vorhergehenden Ansprüche, **dadurch gekennzeichnet, dass** die photovoltaische Vorrichtung eine photovoltaische Zelle ist und dass die ersten Leiter (12) Sammelleiter der photovoltaischen Zelle sind.

11. Photovoltaische Vorrichtung nach dem vorhergehenden Anspruch, **dadurch gekennzeichnet, dass** sie eine photovoltaische Zelle ist, die zueinander parallele Sammelleiter (12), die durch eine konstante Schrittweite (p) getrennt sind, und ein Metallband (13) oder eine Tresse (113), das bzw. die Befestigungszonen (114) aufweist, die mit einer konstanten Schrittweite (P) verteilt und den Sammelleitern (12) überlagert sind, umfasst.

12. Photovoltaische Vorrichtung nach dem vorhergehenden Anspruch, **dadurch gekennzeichnet, dass** die Befestigungszonen (114) mit einer Schrittweite (P) verteilt sind, die ein ganzzahliges Vielfaches der Schrittweite (p) der Sammelleiter (12) ist.

13. Photovoltaische Vorrichtung nach Anspruch 11 oder 12, **dadurch gekennzeichnet, dass** der Abstand (l) zwischen den beiden Verbindungszonen (14) in einem Bereich p - 20 % p ≤ l ≤ p liegt, wobei p die Schrittweite der Sammelleiter (12) ist.

14. Verfahren zum Herstellen elektrischer Leiter auf einer Platte (11) einer photovoltaischen Vorrichtung, **dadurch gekennzeichnet, dass** es die folgenden Schritte umfasst:
- Herstellen eines Drucks durch eine metallische Schablone des Stencil-Typs, um eine Schicht einer leitenden Tinte auf der Oberfläche der Platte (11) abzulagern, derart, dass mehrere erste Leiter (12) in einer ersten Richtung gebildet werden, wobei diese Leiter (12) diskontinuierlich sind und auf Höhe wenigstens einer Verbindungszone (14) unterbrochen sind,
- Herstellen einer elektrischen Verbindung durch Bedecken der Verbindungszonen (14) der ersten Leiter (12) durch die Befestigung wenigstens eines zweiten Leiters (13; 113), der ein Metallband (13) oder eine Tresse (113) ist, auf wenigstens einem ersten elektrischen Leiter (12), wobei dieses Metallband (13) oder diese Tresse (113) Befestigungszonen (114) aufweist, für die es bzw. sie mit einem ersten elektrischen Leiter (12) mechanisch und elektrisch verbunden ist, und Nichtverbindungszonen (115) aufweist, für die sie bzw. es mit einem elektrischen Leiter nicht mechanisch verbunden ist, wobei dieses metallische Band (13) oder diese Tresse (113) die elektrische Verbindung der ersten Leiter (12) untereinander auf Höhe ihrer diskontinuierlichen Zonen verwirklicht.

## Claims

1. Photovoltaic device comprising a wafer (11), **characterized in that** it comprises a plurality of discontinuous first conductors (12) oriented in a first direction, which conductors are interrupted in interconnection zones (14), and **in that** at least one second conductor (13; 113) electrically connects the first conductors (12) to one another in the interconnection zones (14), and **in that** it is fastened to at least one first electrical conductor (12) and comprises fastening zones (114) in which it is mechanically and electrically connected to a first electrical conductor (12) and non-connected zones (115) in which it is not mechanically fastened to an electrical conductor, so that it is discontinuously connected to the first electrical conductors (12), and the least one second conductor being a metal strip (13), such as a copper strip, or a braid (113), which covers the two ends of a first conductor (12) at a discontinuity in an interconnection zone (14) and which covers a plurality of interconnection zones (14) so as to electrically connect a plurality of first conductors (12), this at least one metal strip (13) or braid (113) electrically connecting the first conductors (12) to one another in their discontinuous zones.

2. Photovoltaic device according to the preceding claim, **characterized in that** the end of the first conductors (12), at their discontinuous part in an interconnection zone (14), forms electrical connectors (161, 162; 16) that are wider than the width of the first conductors (12) outside of the interconnection zones (14), and **in that** the interconnection zones (14) are aligned in a second direction that is different from the first direction, so that the second conductor (13; 113) extends from one end of the wafer (11) to the other in this second direction, thereby connecting the aligned interconnection zones.

3. Photovoltaic device according to one of previous claims, **characterized in that** each first conductor (12) takes the form of a plurality of segments that are aligned in the first direction, said segments having a space (15) between them in the interconnection zones (14), this space (15) being larger than or equal to 0.25 mm.

4. Photovoltaic device according to one of previous claims, **characterized in that** each first conductor (12) has a width smaller than 0.12 mm outside of the interconnection zones (14).

5. Photovoltaic device according to one of previous claims, **characterized in that** each first conductor (12) extends from one end of the wafer (11) to the other in the first direction.

6. Photovoltaic device according to one of previous claims, **characterized in that** it comprises additional metallized lands (17) in the interconnection zones (14), which lands are separate from the first conductors (12) and ensure the mechanical strength of the at least one second conductor.

7. Photovoltaic device according to one of previous claims, **characterized in that** the first conductors (12) take the form of a single discontinuous printed ink layer, or the form of two printed ink layers that are superposed and discontinuous in the vertical direction.

8. Photovoltaic device according to one of previous claims, **characterized in that** it comprises at least one non-connected zone (115) between two fastening zones (114) and **in that** the length of the metal strip (13) or braid (113) in the non-connected zone (115) is greater than the distance (I) between the two fastening zones (114).

9. Photovoltaic device according to one of previous claims, **characterized in that** the metal strip (13) or braid (113) is fastened by a conductive fastening means (112) in a fastening zone (114), the fastening means being a solder or a conductive adhesive.

10. Photovoltaic device according to one previous claims, **characterized in that** the photovoltaic device is a photovoltaic cell and **in that** the first conductors (12) are collecting conductors of the photovoltaic cell.

11. Photovoltaic device according to the preceding claim, **characterized in that** it is a photovoltaic cell comprising parallel collecting conductors (12) separated by a constant pitch (p), and a metal strip (13) or braid (113) comprising fastening zones (114) distributed with a constant pitch (P) and superposed on the collecting conductors (12).

12. Photovoltaic device according to the preceding claim, **characterized in that** the fastening zones (114) are distributed with a pitch (P) that is an integer multiple of the pitch (p) of the collecting conductors (12).

13. Photovoltaic device according to either of Claims 11 and 12, **characterized in that** the distance (I) between the two interconnection zones (14) lies in a range p-20%p ≤ l ≤ p, where p is the pitch of the collecting conductors (12).

14. Process for producing electrical conductors on a wafer (11) of a photovoltaic device, **characterized in that** it comprises the following steps:
- printing a layer of conductive ink through a metal stencil, on the surface of the wafer (11) so as to form a plurality of first conductors (12) in a first direction, these conductors (12) being discontinuous and interrupted in at least one interconnection zone (14);
- producing an electrical connection by covering the interconnection zones (14) of the first conductors (12) by fastening at least one second conductor (13; 113) which is a metal strip (13) or braid (113) to at least one electrical conductor (12), this metal strip (13) or braid (113) comprising fastening zones (114) in which it is mechanically and electrically connected to a first electrical conductor (12) and non-connected zones (115) in which it is not mechanically fastened to an electrical conductor and this metal strip (13) or braid (113) electrically connecting the first conductors (12) to one another in their discontinuous zones.
